(19) Europäisches Patentamt
European Patent Office
Office européen des brevets

(11) EP 0 968 568 B1

## (12) EUROPEAN PATENT SPECIFICATION

(45) Date of publication and mention
of the grant of the patent:
**29.06.2005 Bulletin 2005/26**

(21) Application number: **98911466.5**

(22) Date of filing: **04.03.1998**

(51) Int Cl.⁷: **H03L 7/113**

(86) International application number:
**PCT/US1998/004178**

(87) International publication number:
**WO 1998/039847 (11.09.1998 Gazette 1998/36)**

(54) **EMULATING NARROW BAND PHASE-LOCKED LOOP BEHAVIOR ON A WIDE BAND PHASE-LOCKED LOOP**

EMULATION DES VERHALTENS EINES SCHMALBANDIGEN PHASENREGELKREISES AUF EINEM BREITBANDIGEN PHASENREGELKREIS

COMPORTEMENT D'UNE BOUCLE ASSERVIE EN PHASE A BANDE ETROITE A EFFET D'EMULATION SUR UNE BOUCLE ASSERVIE EN PHASE A BANDE LARGE

(84) Designated Contracting States:
**DE FR GB IT SE**

(30) Priority: **04.03.1997 US 526794**

(43) Date of publication of application:
**05.01.2000 Bulletin 2000/01**

(73) Proprietor: **LEVEL ONE COMMUNICATIONS, INC**
**Sacramento, CA 95827 (US)**

(72) Inventors:
• **EVERITT, James**
**Granite Bay, CA 95746 (US)**
• **PARKER, James**
**Rancho Cordova, CA 95670 (US)**

(74) Representative: **Sigh, Erik et al**
**Zacco Denmark A/S,**
**Hans Bekkevolds Allé 7**
**2900 Hellerup (DK)**

(56) References cited:
EP-A- 0 402 113         WO-A-96/17435
US-A- 5 525 935         US-A- 5 546 433

**EP 0 968 568 B1**

**Description**

BACKGROUND OF THE INVENTION

1. Field of the Invention.

The present invention relates generally to phase-locked loop circuits, and more particularly to a phase-locked loop circuit which exhibits a tightly controlled capture range for locking an output signal to a data signal, while also providing a wide frequency capture range for initially pulling the output signal within a wider, predetermined frequency range.

2. Description of Related Art.

Digital data transmission has become increasingly important in the modem communications era. The importance of modem digital data transmission drives the search for more efficient and effective phase-locked loops that are used in data communications systems.

EP 0 402 113 discloses a VCO frequency control circuit. A phase error generator generates a digital phase error signal from an input signal. The phase error signal is converted to a digital frequency error signal by a digital integrator. The error signals are added and the result is supplied to a DAC in the phase-locked loop for providing an analog output indicative of PLL frequency error. Outputs from two DACs are summed and the resultant current is used to adjust the VCO frequency.

WO 96 17435 discloses a steered frequency phase-locked loop. The loop comprises phase and frequency detectors, receiving an output from a VCO. The outputs from the detectors are individually gained and filtered, and fed to a summer. The frequency of the signal produced by a VCO deviates from a free-running frequency depending on the input from the summer.

US 5,546,433 discloses a digital phase-locked loop having frequency offset cancellation circuitry. A phase comparator generates phase error signal samples from a digital data signal. A phase/frequency detector 50 generates either UP or DOWN output pulses depending on whether an output from a frequency synthesizer leads or lags a clock signal from a VCO. A phase error clock signal is generated by a logic circuit, and fed to a counter which integrates the phase error in the signal. The secondary frequency offset value is converted to an analog signal and combined with signals from the phase comparator to generate an analog oscillator control signal.

U.S. 5,525,935 discloses a high-speed bit synchronizer with multi-stage control structure. An output signal from a phase comparator is fed to a phase difference output controller. The output from a frequency comparator is fed to a frequency synchronous signal detector. The phase difference output controller receives either a synchronous or an asynchronous signal from the frequency synchronous signal detector, whereupon the phase difference output controller transfers, or does not transfer, respectively, its output to an integrator.

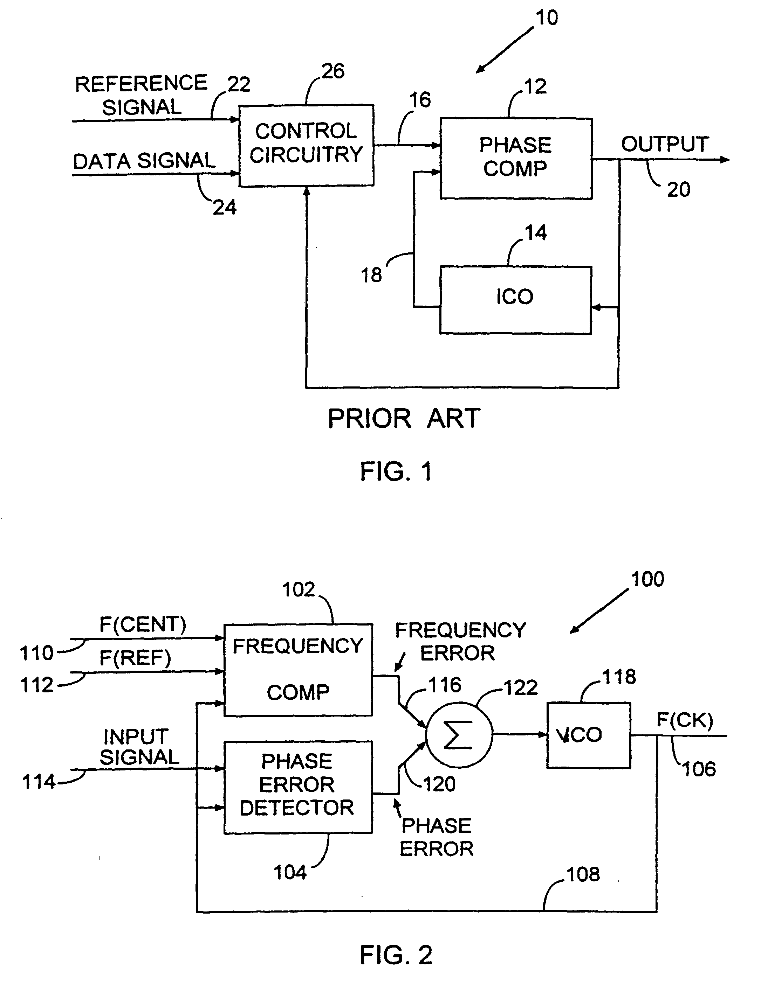

Fig. 1 illustrates a prior art phase-locked loop (PLL) 10 feedback circuit. The PLL 10 is a feedback circuit that is often used to reduce an error term toward zero. In the case of the PLL, the error term is the phase difference between an input signal and a reference signal. The basic component building blocks of a PLL are a phase comparator 12 and a voltage-controlled oscillator (VCO) 14. The PLL incorporates the VCO 14 in the feedback loop. A VCO is an oscillator whose output frequency is a function of its input voltage. The phase comparator 12 compares the phase of the input signal on line 16 to the phase of the signal at the output of the VCO on line 18. If the phase difference between these two signals is non-zero, the output frequency of the VCO 14 is adjusted in a manner which forces this difference down to zero. The output signal on line 20 is fed back to the VCO 14 to provide a signal proportional to the phase difference between the signals on lines 16 and 18.

As is appreciated by those skilled in the art, such a PLL feedback system is often used to extract a baseband signal from a frequency modulated carrier in a communications system. Phase-locked loops are also widely used in communication systems for coherent carrier tracking, and threshold extension, bit synchronization and symbol synchronization. The PLLs as used in the data communications system of the present invention are used to lock to a receive signal and to subsequently provide the receive clock for that signal. Typically, the PLL lock information generated from a data signal is poor, and is therefore not capable of pulling the PLL very far in frequency. Often the frequency range of the PLL is wider than this narrow "capture" range. Under these circumstances, the oscillation frequency of the PLL must somehow be brought close enough to the data signal frequency for the PLL to lock to the data signal. This can be done, as shown in Fig. 1, by first locking the PLL 10 to the frequency of a reference signal on line 22, which is close in frequency to the data signal on line 24. When the PLL 10 is locked to the reference signal on line 22, the input of the PLL 10 is switched over to the data signal on line 24. Although this procedure works, it requires control circuitry 26 to switch from the reference signal on line 22 to the data signal on line 24, and then back again if phase lock is lost.

There is a need, therefore, for a phase-locked loop which has a wide frequency capture range for pulling the PLL within a predetermined frequency range, yet has a well-controlled and narrow frequency capture range for locking to the actual data signal, without the use of switching control circuitry such as control circuitry 26.

SUMMARY OF THE INVENTION

To overcome the limitations in the prior art described above, and to overcome other limitations that will become apparent upon reading and understanding the present specification, the present invention discloses a phase-locked loop that exhibits a tightly controlled capture range for locking an output signal to a data signal, while also providing a wide frequency capture range for initially pulling the output signal within a wider, predetermined frequency range as defined in the appended claims.

The apparatus detects a frequency difference between at least one reference signal and a phase-locked loop (PLL) output signal, and generates a frequency error signal in response to the frequency difference. A phase difference is detected between a received input signal and the PLL output signal, and a phase error signal is generated in response to this phase difference. The frequency error signal and the phase error signal are combined, and this combined signal controls the frequency of the output signal.

One aspect of the invention is that the frequency error signal dominates the concurrently generated phase error signal when the frequency difference is outside of a predetermined frequency range. This dominating signal overdrives the phase error signal by increasing the amplitude of the frequency error signal.

In another embodiment of the present invention, a multiple-stage phase-locked loop (PLL) has an inherently wide actual signal capture range and a narrow effective signal capture range. The PLL includes a first detection mechanism for detecting first phase differences between reference signals and an output signal, and for generating a first phase error signal when the first phase differences fall outside of a predetermined frequency range. The PLL further includes a second detection mechanism for detecting second phase differences between a received input signal and the output signal, and for generating a second phase error signal in response thereto. A signal summing mechanism combines the first phase error signal and the second phase error signal, and allows the first phase error signal to overdrive the second phase error signal when both the first and second phase error signals are active. The PLL also includes a voltage-controlled oscillator to control the frequency of the output signal in response to the first and second phase error signals.

In yet another embodiment of the invention, a method is provided for phase-locking an output signal to a data signal. A frequency error signal is generated where a first frequency difference, measured by the frequency difference between a reference signal and the output signal, is outside of a predetermined frequency range. A phase error signal is generated for a second frequency difference measured by the frequency difference between the data signal and the output signal. Where the first frequency difference is outside of the predetermined frequency range, the frequency error signal overdrives the phase error signal. The frequency of the output signal is controlled with the phase error signal and the frequency error signal.

These and various other advantages and features of novelty which characterize the invention or point out with particularity in the claims annexed hereto and form a part hereof. However, for a better understanding of the invention, its advantages, and the objects obtained by its use, reference should be made to the drawings which form a further part hereof, and to accompanying descriptive matter, in which there is illustrated and described specific examples of an apparatus in accordance with the invention.

BRIEF DESCRIPTION OF THE DRAWINGS

Referring now to the drawings in which like reference numbers represent corresponding parts throughout:

Fig. 1 illustrates a prior art phase-locked loop feedback circuit;
Fig. 2 is a general block diagram of one embodiment of the phase-locked loop of the present invention;
Fig. 3 is a block diagram of a second order phase-locked loop of the present invention;
Fig. 4 is a block diagram of one embodiment of the frequency comparator;
Fig. 5 is a general diagram of the transfer function of the frequency comparator; and
Fig. 6 is a diagram of the transfer function of the frequency comparator with respect to the preferred reference signals.

DETAILED DESCRIPTION OF THE INVENTION

In the following description of the preferred embodiment, reference is made to the accompanying drawings which form a part hereof, and in which is shown by way of illustration the specific embodiment in which the invention may be practiced. It is to be understood that other embodiments may be utilized and structural changes may be made without departing from the scope of the present invention.

The present invention provides a phase-locked loop circuit which exhibits a tightly controlled capture range for locking to a data signal, while also providing a wide frequency capture range for pulling the PLL within a wider frequency range.

Fig. 2 is a general block diagram of one embodiment of the invention. The PLL 100 of Fig. 2 includes a frequency comparator 102 and a phase error detector 104 at the inputs of the PLL 100. The frequency comparator 102 compares the frequency of one or more reference signals to the frequency of a signal to be controlled. The signal to be controlled in Fig. 2 is the output signal, labeled F(CK) on line 106. The F(CK) signal is fed back to the frequency comparator 102 via line 108 to be compared to one or more reference signals. In the preferred embodiment, two reference signals are provided, labeled F(CENT) on line 110 and F(REF) on line 112. PLL 100 compares the frequency of the F(CK) signal on feedback line 108 to a combination of the reference signals on lines 110 and 112. The reference signal combination will be described in more detail in the ensuing description.

The purpose of the frequency comparator 102 is to provide a mechanism for pulling the output of the PLL 100 within a first frequency range from which the phase error detector 104 can then tightly lock to the input signal on line 114. The frequency comparator 102 outputs a frequency error on line 116 that is proportional to the frequency difference between the combination of the reference signals on lines 110, 112, and the F(CK) signal on feedback line 108. Where the frequency of the F(CK) signal on feedback line 108 is greater than a combination of the reference signals F(CENT) and F(REF), a negative frequency error signal will be generated on line 116 to ultimately cause the VCO 118 to decrease the frequency of the F(CK) signal. Where the frequency of the F(CK) signal on feedback line 108 is less than a combination of the reference signals F(CENT) and F(REF), a positive frequency error signal will be generated on line 116 to ultimately cause the VCO 118 to increase the frequency of the F(CK) signal.

The frequency comparator 102 and the phase error detector 104 operate concurrently, however the frequency comparator 102 overrides the phase error detector 104 while the frequency error on line 116 is active. The frequency error is active when the frequency difference, between the F(CK) signal on feedback line 108 and the combination of the reference signals F(CENT) and F(REF) on lines 110 and 112 respectively, is outside of a predetermined frequency range.

This predetermined frequency range is bounded by a cutoff frequency, F(cutoff), above or below the combined reference signal frequency. When the frequency difference is within the predetermined frequency range, the phase error on line 120 is recognized by the VCO 118, which then adjusts the output signal F(CK) on line 106 according to the frequency difference between the F(CK) signal on feedback line 108 and the input signal on line 114. In sum, the frequency comparator 102 first pulls the PLL 100 output signal F(CK) on line 106 to a frequency range defined by the reference signals F(CENT) and F(REF) on lines 110 and 112 respectively. Then, when the F(CK) signal is within the predetermined frequency range, the phase error detector locks the PLL 100 output signal F(CK) to the input signal on line 114.

As previously described, the frequency comparator 102 overrides the phase error detector 104 when the frequency comparator 102 is generating a frequency error signal on line 116. The amplitude of the frequency comparator 102 output on line 116 is selected to be large enough to overdrive the phase error signal on line 120. Therefore, when the frequency difference between the F(CK) signal and the combination of the reference signals F(CENT) and F(REF) is outside of the predetermined frequency range, the frequency comparator 102 provides an amplified error signal which is recognized at the input of the VCO 118.

When this frequency difference is within the predetermined frequency range, the amplified frequency error signal on line 116 is reduced to a near zero value, and the phase error detector 104 then provides the error signal to the input of the VCO 118. Using such an amplified frequency error signal, both the frequency error signal and the phase error signal, on lines 116 and 120 respectively, can be concurrently generated, while allowing only one of the signals to be significantly recognized.

The frequency error signal the phase error signal on lines 116 and 120 are added together at the summing device 122. This allows both the frequency error signal and the phase error signal to be generated concurrently, while providing a single input signal to the VCO 118.

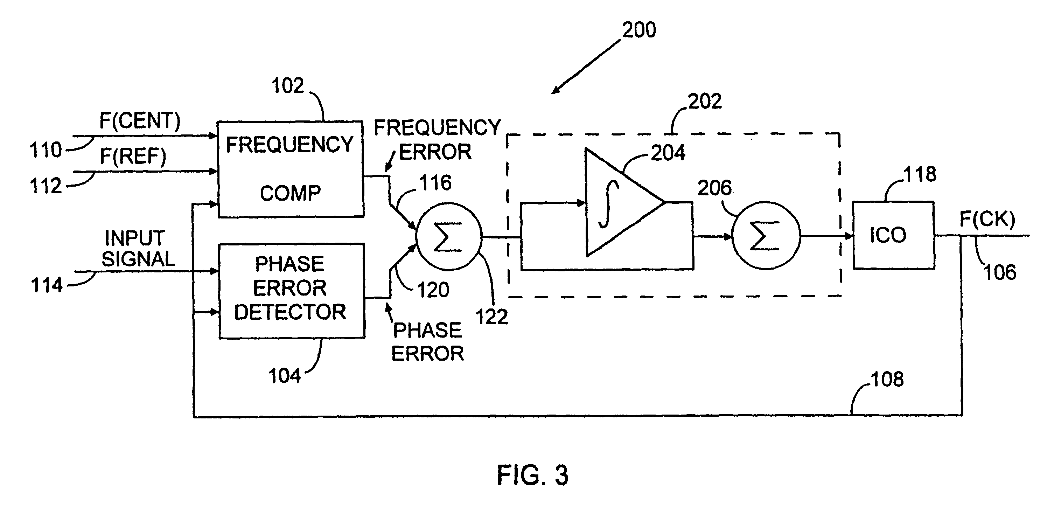

Referring now to Fig. 3, the PLL 200 includes a circuit 202 for changing the order of the phase-locked loop. The PLL 200 is similar to PLL 100 of Fig. 2, as it includes the frequency comparator 102, the phase error detector 104, the summing circuit 122 and the VCO 118. However, these components can be applied to any order PLL. PLL 200 is a second order phase-locked loop, as the circuit 202 includes an integrator 204 and a summing circuit 206. As will be appreciated by those skilled in the art, the inclusion of circuit 202 results in a transfer function having two poles, thereby providing a second-order PLL. Regardless of the order of the PLL, the resulting signal is inputted into the VCO 118 to control the frequency of the output signal F(CK) on line 106. The output signal F(CK) is also fed back into both the frequency comparator 102 and the phase error detector 104. This feedback provides the control signal necessary for the frequency comparator 102 and the phased error detector 104 to lock in on the frequency of the input signal on line 114. Any order PLL can be constructed using the teachings as herein disclosed without departing from the scope and spirit of the invention.

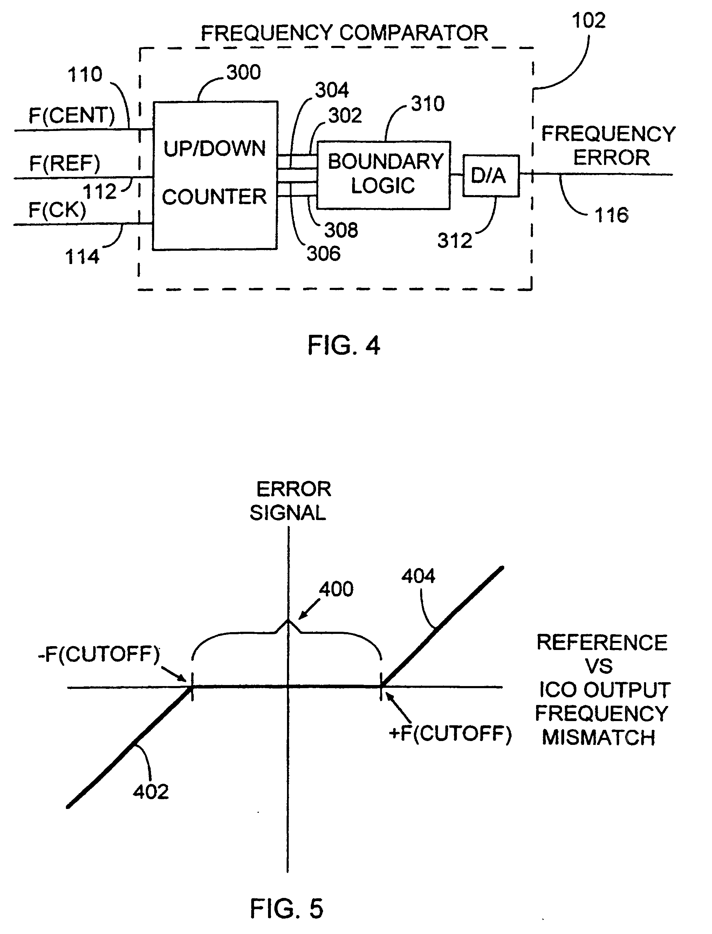

Fig. 4 is a general block diagram of one embodiment of the frequency comparator 102. The preferred frequency comparator 102 is an up/down counter 300 with input signals F(CENT), F(REF) and F(CK) on lines 110, 112 and 114. One possible implementation is a 16-bit counter having four outputs on lines 302, 304, 306 and 308. On the positive edge of an F(CENT) pulse, the counter executes one count towards its center (i.e., it decrements the count if the count is greater than eight, and increments the count if the count is less than eight). On the positive edge of an F(REF) pulse the counter increments, and on the positive edge of an F(CK) pulse the counter decrements.

When the count is greater than 12, the frequency comparator 102 outputs a positive error signal proportional to the amount by which the count is greater than or equal to twelve (hexadecimal C). When the count is less than 4, the frequency comparator 102 outputs a negative error signal proportional to the amount by which the count is less than four.

Other circuitry in the frequency comparator 102 converts the up/down counter 300 value to a signal that can be recognized by the VCO 118. For instance, the boundary logic 310 receives the count value on lines 302 through 308, and determines whether the count is less than four, between four and eleven, or greater than or equal to twelve. If the count is between four and eleven, the boundary logic 310 outputs a binary null value to ultimately generate a near zero frequency error signal on line 116. If the count is less than four, or greater than eleven, the boundary logic passes the value to a digital-to-analog (D/A) converter 312 that generates a proportional frequency error signal on line 116.

It can be shown that the up/down counter 300 counts down and therefore produces a negative frequency error signal when F(CK)-F(REF) > F(CENT), which would indicate that the F(CK) signal is oscillating at a faster rate than the F(REF) and F(CENT) reference signal combination. The up/down counter 300 counts up and therefore produces a positive frequency error signal when F(CK)-F(REF) < F(CENT), which would indicate that the F(CK) signal is oscillating at a slower rate than the F(REF) and F(CENT) reference signal combination. The up/down counter 300 counts toward the center and therefore produces zero output when |F(CK)-F(REF)| < F(CENT). This indicates that the zone where the frequency comparator 102 no longer overdrives the phase error signal on line 120 is within the predetermined frequency range defined by F(REF)-F(CENT) to F(REF)+F(CENT). Since F(REF) and F(CENT) are crystal controlled clocks in the preferred embodiment, the capture range is tightly controlled and can be made very narrow. This result is independent of the exact counter details implemented.

Referring now to Table 1, the frequency comparator 102 output, i.e., the frequency error signal on line 116, is shown for each count of a 16-bit up/down counter 300. As can be seen, a negative frequency error signal, labeled -ERR, is generated for binary values of 0 to 3. The -ERR signal is proportional to the amount by which the count is less than four. The +ERR signal is proportional to the amount by which the count is greater than or equal to twelve. Where the count is between four and eleven, the frequency error signal, shown as ERR, is approximately equal to zero.

TABLE 1

| COUNTER OUTPUT | FREQUENCY COMPARATOR OUTPUT |
|---|---|
| 0 0 0 0 | |
| 0 0 0 1 | -ERR $\propto$ (4-COUNT) |
| 0 0 1 0 | |
| 0 0 1 1 | |
| 0 1 0 0 | |
| 0 1 0 1 | |
| 0 1 1 0 | |
| 0 1 1 1 | ERR = 0 |
| 1 0 0 0 | |
| 1 0 0 1 | |
| 1 0 1 0 | |
| 1 0 1 1 | |
| 1 1 0 0 | |
| 1 1 0 1 | +ERR $\propto$ (COUNT-12) |
| 1 1 1 0 | |
| 1 1 1 1 | |

Fig. 5 is a diagram of the transfer function of the frequency comparator 102 of Fig. 4. Fig. 5 illustrates the frequency error signal on line 116 as plotted against the frequency mismatch of the reference signals and the VCO 118 output. As is evident from Fig. 5, where the reference signals and the VCO output are relatively close in frequency, no error signal is generated by the frequency comparator 102 within the predetermined frequency range 400. It is within this frequency range 400 that the frequency error on line 116 does not dominate the phase error signal on line 120, and the phase error signal allows the input signal on line 114 to be locked as the F(CK) signal on line 106. The lower range of the frequency mismatch is shown in Fig. 5 as the minus cutoff frequency, -F(CUTOFF), and the upper range of the frequency mismatch is shown as the positive cutoff frequency, +F(CUTOFF). These cutoff frequencies define the boundaries of the predetermined frequency range outside of which the frequency error signal controls. At mismatch frequencies below the minus cutoff frequency, it can be seen that a negative error signal is generated which is proportional to the magnitude of the frequency mismatch. Likewise, frequency mismatches above the positive cutoff frequency increase linearly as the frequency mismatch increases beyond its upper range.

For the frequency comparator 102 as shown in Fig. 4, the up/down counter 300 will decrement the count when the F(CK) signal is greater than the sum of the reference signals as shown in Equation 1 below.

$$F_{(CK)} > F_{(REF)} + F_{(CENT)} \qquad \text{[EQUATION 1]}$$

When the F(CK) signal is greater than the sum of the reference signals, the operating point moves to the left on the transfer function of Fig. 5 until a negative error signal occurs, which is proportional to the magnitude of the frequency mismatch, as seen by line 402.

The up/down counter 300 will increment the count when the F(CK) signal is less than the difference of the F(REF) and F(CENT) signals as shown in Equation 2 below.

$$F_{(CK)} < F_{(REF)} - F_{(CENT)} \qquad \text{[EQUATION 2]}$$

When the F(CK) signal is less than the difference of the F(REF) and F(CENT) signals, the operating point moves to the right on the transfer function until a positive error signal occurs, which is proportional to the magnitude of the frequency mismatch, as seen by line 404.

When the magnitude of the difference between the F(CK) and F(REF) signals is less than the frequency of F(CENT), as shown in Equation 3 below, the operating point stays within the predetermined frequency range 400.

$$F_{(CENT)} > |F_{(CK)} - F_{(REF)}| \qquad \text{[EQUATION 3]}$$

It will be readily recognized by those skilled in the art that counters larger or smaller than a 16-bit counter may be used without departing from the invention, and only the precise location of the -F(CUTOFF) and the +F(CUTOFF) will be affected.

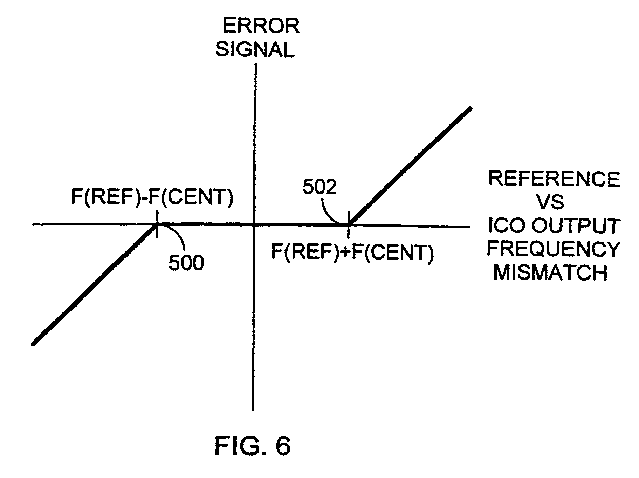

Referring now to Fig. 6, a diagram of the transfer function of the frequency comparator 102 is shown having the frequency cutoff values as determined by Equations 1 and 2. The -F(CUTOFF) frequency, shown at point 500, can be represented by F(REF)-F(CENT), as shown in Equation 2. The +F(CUTOFF) frequency, shown at point 502, can be represented by F(REF)+F(CENT), as shown in Equation 1. Therefore, the capture range is set by controlling the frequencies of the F(REF) and F(CENT) signals. By using crystal controlled signals, this range can be tightly controlled.

The foregoing description of the preferred embodiment of the invention has been presented for the purposes of illustration and description. It is not intended to be exhaustive or to limit the invention to the precise form disclosed. Many modifications and variations are possible in light of the above teaching. It is intended that the scope of the invention be limited not by this detailed description, but rather by the claims appended hereto.

**Claims**

1. A phase-locked loop (PLL), comprising:

   frequency compare means (102) for detecting a frequency difference between a reference signal (110, 112) and a PLL output signal (108), and for generating a frequency error signal in response thereto,

   phase error detection means for detecting a phase difference between a received input signal (114) and the PLL output signal, and for generating a phase error signal in response thereto;

   signal summing means (122), coupled to the phase error detection means and the frequency compare means, for combining the phase error signal and the frequency error signal to form a combined error signal; and

   a voltage-controlled oscillator (118) having an input terminal coupled to receive the combined error signal and an output terminal to output the variable frequency PLL output signal in response thereto,

   **characterized in that** the frequency compare means (102) comprises means for generating a dominating frequency error signal to overdrive the phase error signal and to dominate the combined error signal when the frequency difference is outside of a frequency range defined by a combination of multiple reference signals (110, 112).

2. A phase-locked loop according to claim 1, **characterized in that** the frequency compare means comprises means for increasing the amplitude of the frequency error signal to create the dominating frequency error signal.

3. A phase-locked loop according to claim 2, **characterized in that** the amplitude of the frequency error signal is increased so that it overdrives the phase error signal.

4. A phase-locked loop according to claim 1, **characterized in that** the frequency compare means comprises wide band means for detecting a wider range of frequency differences than the differences detected by the phase error detection means.

5. A phase-locked loop according to claim 1, **characterized in that** the frequency compare means comprises means for detecting the frequency difference in a first frequency range, and wherein the phase error detection means comprises means for detecting the frequency difference in a second frequency range smaller than the first frequency range.

**6.** A phase-locked loop according to claim 1, **characterized in that**:

a frequency variance between the combination of the multiple reference signals and the PLL output signal defines a frequency variance range; and

the frequency error signal is recognized when the frequency variance is beyond the frequency variance range, and the phase error signal is recognized when the frequency variance is within the frequency variance range.

**7.** A phase-locked loop according to claim 1, **characterized by** further comprising an integrator (204) coupled between the signal summing means and the voltage-controlled oscillator to provide a second-order PLL.

**8.** A phase-locked loop according to claim 1, **characterized in that** the frequency compare means, the phase error detection means, the signal summing means, and the voltage-controlled oscillator are applied to any order PLL.

**9.** A phase-locked loop according to claim 1, **characterized in that** the magnitude of the frequency error signal is proportional to the magnitude of the frequency difference between the reference signal and the PLL output signal.

**10.** A phase-locked loop according to claim 1, **characterized in that**:

the frequency compare means comprises an n-bit counter having the reference signal and the PLL output signal as inputs; and

the value of the frequency error signal is dependent on the counter value.

**11.** A method for phase-locking a PLL output signal (106) to a received input signal (114), comprising the steps of:

generating a frequency error signal in response to detecting that a frequency difference between a reference signal (110, 112) and the PLL output signal is outside of a predetermined frequency range;

generating a phase error signal in response to detecting a phase difference between the received input signal (114) and the PLL output signal (106),

summing the frequency error signal (116) and the phase error signal (120) to form a combined error signal, and

generating the variable frequency PLL output signal (106) in response to the combined error, signal,

**characterized in that** generating the frequency error signal when the frequency difference is outside a predetermined frequency range includes generating a dominating frequency error signal to overdrive the phase error signal and dominate the combined error signal when the frequency difference is outside a predetermined frequency range defined by a combination of multiple reference signals (110, 112).

**12.** A method according to claim 11, **characterized in that** the step of generating the dominating frequency error signal further comprises the step of increasing the amplitude of the frequency error signal to overdrive the phase error signal.

**13.** A method according to claim 11, **characterized in that** the step of generating a phase error signal comprises the step of detecting a phase difference less than the frequency difference.

**14.** A method according to claim 11, **characterized in that** the reference signal comprises a plurality of frequency-regulated signals.

**15.** A method according to claim 14, **characterized in that**:

the step of generating a frequency error signal comprises the steps of determining a frequency variance range bounded by a frequency variance between a combination of the plurality of frequency-regulated signals and the output signal, and recognizing the frequency error signal when the frequency variance is outside of the frequency variance range; and

the step of generating a phase error signal for the phase difference comprises the step of recognizing the phase error signal when the frequency variance is within the frequency variance range.

16. A method according to claim 11, **characterized in that** the step of generating a frequency error signal comprises the steps of varying an up/down count in accordance with the number of pulses occurring on the reference signals and the output signal, and for generating the frequency error signal when the up/down count is outside of a predetermined count range corresponding to a predetermined frequency range.

17. A phase-locked loop according to claim 1, **characterized in that** the frequency compare means and phase error detection means detect the frequency difference and the phase difference concurrently.

18. A phase-locked loop according to claim 1, **characterized in that** the frequency differences are larger than the phase differences.

19. A phase-locked loop according to claim 18, **characterized in that** the voltage controlled oscillator comprises means for first controlling the frequency of the PLL output signal in response to the frequency error signal, and for subsequently controlling the frequency of the PLL output signal in response to the phase error signal.

20. A phase-locked loop according to claim 1, **characterized in that** the frequency compare means comprises counting means (300) for varying an up/down count in accordance with the number of pulses occurring on the reference signal and the PLL output signal, and for generating the frequency error signal when the up/down count is outside of a predetermined count range which corresponds to the frequency range.

21. A phase-locked loop according to claim 20, **characterized in that** the counting means (300) comprises means (310) for increasing the up/down count and generating a positive frequency error signal when the up/down count is above an upper count of the predetermined count range.

22. A phase-locked loop according to claim 21, **characterized in that** the positive frequency error signal causes the frequency of the PLL output signal to increase.

23. A phase-locked loop according to claim 20, **characterized in that** the counting means (300) comprises means (310) for decreasing the up/down count and generating a negative frequency error signal when the up/down count is below a lower count of the predetermined count range.

24. A phase locked loop according to claim 23, **characterized in that** the negative frequency error signal causes the frequency of the PLL output signal to decrease.

**Patentansprüche**

1. Phasenregelkreis (PLL) mit:

einem Frequenzvergleichsmittel (102) um einen Frequenzunterschied zwischen einem Bezugssignal (110, 112) und einem Phasenregelkreis-Ausgangssignal (108) zu erfassen und als Reaktion hierauf ein Frequenzfehlersignal zu erzeugen,

einem Phasenfehlererfassungsmittel, um ein Phasenunterschied zwischen einem empfangenen Eingangssignal (114) und dem Phasenregelkreis-Ausgangssignal zu erfassen und als Reaktion hierauf ein Phasenfehlersignal zu erzeugen;

an das Phasenfehlererfassungsmittel und das Frequenzvergleichsmittel gekoppelten Signalsummiermitteln (122), um das Phasenfehlersignal und das Frequenzfehlersignal zum Bilden eines Kombinationsfehlersignals zu kombinieren; und

einem spannungsgesteuerten Oszillator (118) mit einem Eingangsanschluß, welche gekoppelt ist, um das Kombinationsfehlersignal zu empfangen und einem Ausgangsanschluß, um als Reaktion hierauf das Phasenregelkreis-Ausgangssignal veränderlicher Frequenz auszugeben,

**dadurch gekennzeichnet, daß** das Frequenzvergleichsmittel (102) Mittel zum Erzeugen eines dominierenden Frequenzfehlersignals umfaßt, um das Phasenfehlersignal zu übersteuern und das Kombinationsfehlersignal zu dominieren, wenn der Frequenzunterschied außerhalb eines Frequenzbereichs liegt, welcher durch eine Kombination mehrerer Bezugssignale (110, 112) definiert ist.

2. Phasenregelkreis nach Anspruch 1, **dadurch gekennzeichnet, daß** das Frequenzvergleichsmittel Mittel zum Erhöhen der Amplitude des Frequenzfehlersignals umfaßt, um das dominierende Frequenzfehlersignal zu erzeugen.

3. Phasenregelkreis nach Anspruch 2, **dadurch gekennzeichnet, daß** die Amplitude des Frequenzfehlersignals so erhöht wird, daß es das Phasenfehlersignal übersteuert.

4. Phasenregelkreis nach Anspruch 1, **dadurch gekennzeichnet, daß** das Frequenzvergleichsmittel Breitbandmittel zum Erfassen eines breiteren Bereichs an Frequenzunterschieden als die vom Phasenfehlererfassungsmittel erfaßten Unterschiede aufweist.

5. Phasenregelkreis nach Anspruch 1, **dadurch gekennzeichnet, daß** das Frequenzvergleichsmittel Mittel zum Erfassen des Frequenzunterschieds in einem ersten Frequenzbereich umfaßt und das Phasenfehlererfassungsmittel Mittel zum Erfassen des Frequenzunterschieds in einem zweiten Frequenzbereich umfaßt, welche kleiner ist als der erste Frequenzbereich.

6. Phasenregelkreis nach Anspruch 1, **dadurch gekennzeichnet, daß**
eine Frequenzabweichung zwischen der Kombination der mehreren Bezugssignale und dem Phasenregelkreis-Ausgangssignal einen Frequenzabweichbereich definiert; und
das Frequenzfehlersignal erkannt wird, wenn die Frequenzabweichung jenseits des Frequenzabweichbereichs liegt und das Phasenfehlersignal erkannt wird, wenn die Frequenzabweichung innerhalb des Frequenzabweichbereichs liegt.

7. Phasenregelkreis nach Anspruch 1, **gekennzeichnet durch** einen Integrierer (204), welcher zwischen den Signalsummiermitteln und dem spannungsgesteuerten Oszillator gekoppelt ist, um einen Phasenregelkreis zweiter Ordnung bereitzustellen.

8. Phasenregelkreis nach Anspruch 1, **dadurch gekennzeichnet, daß** das Frequenzvergleichsmittel, das Phasenfehlererfassungsmittel, die Signalsummiermittel und der spannungsgesteuerte Oszillator an Phasenregelkreise jeder Ordnung angewendet werden.

9. Phasenregelkreis nach Anspruch 1, **dadurch gekennzeichnet, daß** die Größe des Frequenzfehlersignals zur Größe des Frequenzunterschieds zwischen dem Bezugssignal und dem Phasenregelkreis-Ausgangssignal proportional ist.

10. Phasenregelkreis nach Anspruch 1, **dadurch gekennzeichnet, daß**
das Frequenzvergleichsmittel einen n-Bit-Zähler mit dem Bezugssignal und dem Phasenregelkreis-Ausgangssignal als Eingaben umfaßt; und
der Wert des Frequenzfehlersignals vom Zählerwert abhängt.

11. Verfahren zum Phasenverriegeln eines Phasenregelkreis-Ausgangssignals (106) mit einem empfangenen Eingangssignal (114), welches die folgenden Schritte umfaßt:

Erzeugen eines Frequenzfehlersignals als Reaktion auf das Erfassen, daß ein Frequenzunterschied zwischen einem Bezugssignal (110, 112) und dem Phasenregelkreis-Ausgangssignal außerhalb eines vorbestimmten Frequenzbereichs liegt;

Erzeugen eines Phasenfehlersignals als Reaktion auf das Erfassen eines Phasenunterschieds zwischen dem empfangenen Eingangssignal (114) und dem Phasenregelkreis-Ausgangssignal (106);

Summieren des Frequenzfehlersignals (116) und des Phasenfehlersignals (120) zur Bildung eines Kombinationsfehlersignals; und

Erzeugen eines Phasenregelkreis-Ausgangssignals variabler Frequenz (106) als Reaktion auf das Kombinationsfehlersignal,

**dadurch gekennzeichnet, daß** das Erzeugen des Frequenzfehlersignals das Erzeugen eines dominanten Frequenzfehlersignals umfaßt, um das Phasenfehlersignal zu übersteuern und das Kombinationsfehlersignal zu dominieren, wenn der Frequenzunterschied außerhalb eines Frequenzbereichs liegt, welche durch eine Kombination mehrerer Bezugssignale (110, 112) definiert ist.

12. Verfahren nach Anspruch 11, **dadurch gekennzeichnet, daß** das Erzeugen des dominierenden Frequenzfehlersignals das Erhöhen der Amplitude des Frequenzfehlersignals umfaßt, um das Phasenfehlersignal zu übersteuern.

13. Verfahren nach Anspruch 11, **dadurch gekennzeichnet, daß** das Erzeugen eines Phasenfehlersignals das Erfassen eines Phasenunterschieds umfaßt, welcher kleiner ist als der Frequenzunterschied.

14. Verfahren nach Anspruch 11, **dadurch gekennzeichnet, daß** das Bezugssignal mehrere frequenzregulierte Signale umfaßt.

15. Verfahren nach Anspruch 14, **dadurch gekennzeichnet, daß**
das Erzeugen eines Frequenzfehlersignals das Bestimmen eines Frequenzabweichbereichs, welches von einer Frequenzabweichung zwischen einer Kombination der mehreren frequenzregulierten Signale und dem Ausgangssignal begrenzt ist, und das Erkennen des Frequenzfehlersignals umfaßt, wenn die Frequenzabweichung außerhalb des Frequenzabweichbereichs liegt; und
das Erzeugen eines Phasenfehlersignals für den Phasenunterschied das Erkennen des Phasenfehlersignals umfaßt, wenn die Frequenzabweichung innerhalb des Frequenzabweichbereichs liegt.

16. Verfahren nach Anspruch 11, **dadurch gekennzeichnet, daß** das Erzeugen eines Frequenzfehlersignals das Ändern einer Aufwärts- / Abwärts-Zählung nach der Anzahl auf den Bezugssignalen und dem Ausgangssignal auftretender Impulse und das Erzeugen des Frequenzfehlersignals umfaßt, wenn die Aufwärts- / Abwärts-Zählung außerhalb eines vorbestimmten Zählbereichs liegt, welche einem vorbestimmten Frequenzbereich entspricht.

17. Phasenregelkreis nach Anspruch 1, **dadurch gekennzeichnet, daß** das Frequenzvergleichsmittel und das Phasenfehlererfassungsmittel den Frequenzunterschied und den Phasenunterschied gleichzeitig erfassen.

18. Phasenregelkreis nach Anspruch 1, **dadurch gekennzeichnet, daß** die Frequenzunterschiede größer sind als die Phasenunterschiede.

19. Phasenregelkreis nach Anspruch 18, **dadurch gekennzeichnet, daß** der spannungsgesteuerte Oszillator Mittel aufweist, um zuerst die Frequenz des Phasenregelkreis-Ausgangssignals als Reaktion auf das Frequenzfehlersignal zu steuern und um anschließend die Frequenz des Phasenregelkreis-Ausgangssignals als Reaktion auf das Phasenfehlersignal zu steuern.

20. Phasenregelkreis nach Anspruch 1, **dadurch gekennzeichnet, daß** das Frequenzvergleichsmittel Zählmittel (300) umfaßt, um eine Aufwärts- / Abwärts-Zählung nach der Anzahl der auf dem Bezugssignal und dem Phasenregelkreisen-Ausgangssignal auftretenden Impulse zu ändern und das Frequenzfehlersignal zu erzeugen, wenn die Aufwärts- / Abwärts-Zählung außerhalb eines vorbestimmten Zählbereichs liegt, welche dem Frequenzbereich entspricht.

21. Phasenregelkreis nach Anspruch 20, **dadurch gekennzeichnet, daß** das Zählmittel (300) Mittel (310) aufweist, um die Aufwärts- / Abwärts-Zählung zu erhöhen und ein positives Frequenzfehlersignal zu erzeugen, wenn die Aufwärts- / Abwärts-Zählung oberhalb einer oberen Zählung des vorbestimmten Zählbereichs liegt.

22. Phasenregelkreis nach Anspruch 21, **dadurch gekennzeichnet, daß** das positive Frequenzfehlersignal das Erhöhen der Frequenz des Phasenregelkreis-Ausgangssignals verursacht:

23. Phasenregelkreis nach Anspruch 20, **dadurch gekennzeichnet, daß** das Zählmittel (300) Mittel (310) umfaßt, um die Aufwärts- / Abwärts-Zählung zu reduzieren und ein negatives Frequenzfehlersignal zu erzeugen, wenn die Aufwärts- / Abwärts-Zählung unterhalb einer unteren Zählung des vorbestimmten Zählbereichs liegt.

24. Phasenregelkreis nach Anspruch 23, **dadurch gekennzeichnet, daß** das negative Frequenzfehlersignal das Reduzieren der Frequenz des Phasenregelkreis-Ausgangssignals verursacht.


**Revendications**

1. Boucle à phase asservie (PLL), comprenant :

   un moyen de comparaison de fréquences (102) servant à détecter une différence de fréquence entre un signal de référence (110, 112) et un signal de sortie (108) de boucle à phase asservie, et à produire un signal d'erreur de fréquence en réponse à celle-ci,
   un moyen de détection d'erreur de phase servant à détecter une différence de phase entre un signal d'entrée reçu (114) et le signal de sortie de boucle à phase asservie, et à produire un signal d'erreur de phase en réponse à celle-ci ;
   un moyen de sommation de signaux (122), couplé au moyen de détection d'erreur de phase et au moyen de comparaison de fréquences, servant à combiner le signal d'erreur de phase et le signal d'erreur de fréquence pour former un signal d'erreurs combinées ; et
   un oscillateur commandé en tension (118) comportant une borne d'entrée couplée pour recevoir le signal d'erreurs combinées et une borne de sortie servant à délivrer le signal de sortie de boucle à phase asservie à fréquence variable en réponse à celui-ci,

   **caractérisée en ce que** le moyen de comparaison de fréquences (102) comprend un moyen servant à produire un signal d'erreur de fréquence dominant pour surattaquer le signal d'erreur de phase et dominer le signal d'erreurs combinées lorsque la différence de fréquence est extérieure à une gamme de fréquences définie par une combinaison de plusieurs signaux de référence (110, 112).

2. Boucle à phase asservie selon la revendication 1, **caractérisée en ce que** le moyen de comparaison de fréquences comprend un moyen servant à augmenter l'amplitude du signal d'erreur de fréquence dans le but de créer le signal d'erreur de fréquence dominant.

3. Boucle à phase asservie selon la revendication 2, **caractérisée en ce que** l'amplitude du signal d'erreur de fréquence est augmentée de sorte qu'il surattaque le signal d'erreur de phase.

4. Boucle à phase asservie selon la revendication 1, **caractérisée en ce que** le moyen de comparaison de fréquences comprend un moyen à large bande servant à détecter une gamme de différences de fréquences plus grande que les différences détectées par le moyen de détection d'erreur de phase.

5. Boucle à phase asservie selon la revendication 1, **caractérisée en ce que** le moyen de comparaison de fréquences comprend un moyen servant à détecter la différence de fréquence dans une première gamme de fréquences, et dans lequel le moyen de détection d'erreur de phase comprend un moyen servant à détecter la différence de fréquence dans une seconde gamme de fréquences plus petite que la première gamme de fréquences.

6. Boucle à phase asservie selon la revendication 1, **caractérisée en ce que** :

   une variation de fréquence entre la combinaison de plusieurs signaux de référence et le signal de sortie de boucle à phase asservie définit une gamme de variation de fréquence ; et
   le signal d'erreur de fréquence est reconnu lorsque la variation de fréquence est au-delà de la gamme de variation de fréquence, et le signal d'erreur de phase est reconnu lorsque la variation de fréquence est à l'intérieur de la gamme de variation de fréquence.

7. Boucle à phase asservie selon la revendication 1, **caractérisée par le fait qu'**elle comprend en outre un intégrateur (204) couplé entre le moyen de sommation de signaux et l'oscillateur commandé en tension, dans le but d'obtenir une boucle à phase asservie de second ordre.

8. Boucle à phase asservie selon la revendication 1, **caractérisée en ce que** le moyen de comparaison de fréquences, le moyen de détection d'erreur de phase, le moyen de sommation de signaux et l'oscillateur commandé en tension sont appliqués à une boucle à phase asservie d'ordre quelconque.

9.  Boucle à phase asservie selon la revendication 1, **caractérisée en ce que** l'amplitude du signal d'erreur de fréquence est proportionnelle à l'amplitude de la différence de fréquence entre le signal de référence et le signal de sortie de boucle à phase asservie.

10. Boucle à phase asservie selon la revendication 1, **caractérisée en ce que** :

   le moyen de comparaison de fréquences comprend un compteur de n bits ayant le signal de référence et le signal de sortie de boucle à phase asservie en tant qu'entrées ; et
   la valeur du signal d'erreur de fréquence dépend de la valeur de compteur.

11. Procédé d'asservissement de phase d'un signal de sortie (106) de boucle à phase asservie à un signal d'entrée reçu (114), comprenant les étapes :

   de production d'un signal d'erreur de fréquence en réponse à la détection du fait qu'une différence de fréquence entre un signal de référence (110, 112) et le signal de sortie de boucle à phase asservie est extérieure à une gamme de fréquences prédéterminée ;
   de production d'un signal d'erreur de phase en réponse à la détection d'une différence de phase entre le signal d'entrée reçu (114) et le signal de sortie (106) de boucle à phase asservie,
   de sommation du signal d'erreur de fréquence (116) et du signal d'erreur de phase (120) pour former un signal d'erreurs combinées, et
   de production du signal de sortie (106) de boucle à phase asservie à fréquence variable en réponse au signal d'erreurs combinées,

   **caractérisé en ce que** la production du signal d'erreur de fréquence, lorsque la différence de fréquence est extérieure à une gamme de fréquences prédéterminée, inclut la production d'un signal d'erreur de fréquence dominant pour surattaquer le signal d'erreur de phase et dominer le signal d'erreurs combinées lorsque la différence de fréquence est extérieure à une gamme de fréquences prédéterminée définie par une combinaison de plusieurs signaux de référence (110, 112).

12. Procédé selon la revendication 11, **caractérisé en ce que** l'étape de production du signal d'erreur de fréquence dominant comprend en outre l'étape d'augmentation de l'amplitude du signal d'erreur de fréquence pour surattaquer le signal d'erreur de phase.

13. Procédé selon la revendication 11, **caractérisé en ce que** l'étape de production d'un signal d'erreur de phase comprend l'étape de détection d'une différence de phase inférieure à la différence de fréquence.

14. Procédé selon la revendication 11, **caractérisé en ce que** le signal de référence comprend plusieurs signaux régulés en fréquence.

15. Procédé selon la revendication 14, **caractérisé en ce que** :

   l'étape de production d'un signal d'erreur de fréquence comprend les étapes de détermination d'une gamme de variation de fréquence délimitée par une variation de fréquence entre une combinaison des plusieurs signaux régulés en fréquence et du signal de sortie, et la reconnaissance du signal d'erreur de fréquence lorsque la variation de fréquence est extérieure à la gamme de variation de fréquence ; et
   l'étape de production d'un signal d'erreur de phase destiné à la différence de phase comprend l'étape de reconnaissance du signal d'erreur de phase lorsque la variation de fréquence est à l'intérieur de la gamme de variation de fréquence.

16. Procédé selon la revendication 11, **caractérisé en ce que** l'étape de production d'un signal d'erreur de fréquence comprend les étapes de variation d'un compte croissant / décroissant en fonction du nombre d'impulsions apparaissant sur les signaux de référence et le signal de sortie, et la production du signal d'erreur de fréquence lorsque le compte croissant / décroissant est extérieur à une plage de compte prédéterminée correspondant à une gamme de fréquences prédéterminée.

**17.** Boucle à phase asservie selon la revendication 1, **caractérisée en ce que** le moyen de comparaison de fréquences et le moyen de détection d'erreur de phase détectent simultanément la différence de fréquence et la différence de phase.

**18.** Boucle à phase asservie selon la revendication 1, **caractérisée en ce que** les différences de fréquences sont plus grandes que les différences de phases.

**19.** Boucle à phase asservie selon la revendication 18, **caractérisée en ce que** l'oscillateur commandé en tension comprend un moyen destiné à commander d'abord la fréquence du signal de sortie de boucle à phase asservie en réponse au signal d'erreur de fréquence, et à commander ultérieurement la fréquence du signal de sortie de boucle à phase asservie en réponse au signal d'erreur de phase.

**20.** Boucle à phase asservie selon la revendication 1, **caractérisée en ce que** le moyen de comparaison de fréquences comprend un moyen de comptage (300) servant à faire varier un compte croissant / décroissant en fonction du nombre d'impulsions apparaissant sur le signal de référence et sur le signal de sortie de boucle à phase asservie, et à produire le signal d'erreur de fréquence lorsque le compte croissant /décroissant est extérieur à une plage de compte prédéterminée qui correspond à la gamme de fréquences.

**21.** Boucle à phase asservie selon la revendication 20, **caractérisée en ce que** le moyen de comptage (300) comprend un moyen (310) servant à incrémenter le compte croissant / décroissant et à produire un signal d'erreur de fréquence positif lorsque le compte croissant / décroissant est au-delà d'un compte supérieur de la plage de compte prédéterminée.

**22.** Boucle à phase asservie selon la revendication 21, **caractérisée en ce que** le signal d'erreur de fréquence positif provoque une augmentation de la fréquence du signal de sortie de boucle à phase asservie.

**23.** Boucle à phase asservie selon la revendication 20, **caractérisée en ce que** le moyen de comptage (300) comprend un moyen (310) servant à décrémenter le compte croissant / décroissant et à produire un signal d'erreur de fréquence négatif lorsque le compte croissant / décroissant est en deçà d'un compte inférieur de la plage de compte prédéterminée.

**24.** Boucle à phase asservie selon la revendication 23, **caractérisée en ce que** le signal d'erreur de fréquence négatif provoque une baisse de la fréquence du signal de sortie de boucle à phase asservie.

PRIOR ART

FIG. 1

FIG. 2

FIG. 3

FREQUENCY COMPARATOR

110

F(CENT)

F(REF)

112

F(CK)

114

300

UP/DOWN
COUNTER

304
302

310

BOUNDARY
LOGIC

308
306

D/A

312

102

FREQUENCY
ERROR

116

FIG. 4

ERROR
SIGNAL

400

404

-F(CUTOFF)

+F(CUTOFF)

402

REFERENCE
VS
ICO OUTPUT
FREQUENCY
MISMATCH

FIG. 5

FIG. 6